# EUROPEAN PATENT APPLICATION

(11) **EP 1 491 138 A1**
(43) Date of publication of application: **29.12.2004**
(21) Application number: 03714628.9
(22) Date of filing: 28.03.2003
(51) Int. Cl.: A61B 5/055

(54) **A PERMANENT MAGNET FOR MAGNET RESONANCE**

(30) Priority: 01.04.2002 CN 02210965
(71) Applicant: Shenyang Neusoft BOPU NMR Tech Co., Ltd., Shenyang, Liaoning 110179 (CN)
(72) Inventor: XIAO, Shengqian, Shenyang, Liaoning 110179 (CN); ZHAO, Shijie, Shenyang, Liaoning 110179 (CN); CHEN, Guangran, Shenyang, Liaoning 110179 (CN)
(74) Representative: Kupiainen, Juhani Kalervo
(86) International application number: PCT/CN2003/000229
(87) International publication number: WO 2003/082106

(57) **Abstract**

The present invention discloses a permanent magnet for magnetic resonance, which is used for a magnetic resonance imaging apparatus for medical diagnosis. The permanent magnet of the present comprises a yoke; magnetic material; pole heads; plates for eliminating vortex; rings for uniformising magnetic field; and gradient coils, said yoke of the magnet has an integral and substantially C-shaped structure with two columns and is open type. This invention fully ensures the parallelism of the lower and upper poles, greatly improves the mechanical strength of the yoke, and it can offer good magnetic uniformity and fluent magnetic current.

## Description

### TECHNICAL FIELD

The present invention generally relates to a medical apparatus, and more particularly to a permanent magnet used for magnetic resonance imaging for medical diagnosis.

### BACKGROUND ART

The magnetic resonance imaging apparatus is a medical apparatus developed in 1980's, and the most advanced clinical diagnosis apparatus for diagnosing precancer and other diseases. The magnet is a key part of the magnetic resonance imaging apparatus, SNR (signal-to-noise ratio) of the magnetic resonance imaging apparatus has a direct relation to the performance of the magnet, so that performance of the magnet determines the quality of the image to a certain extent. The permanent magnet has a simple structure without additional means and is convenient to maintain, can be operated safely, and area of the stray magnetic field therearound is small, therefore, the scientific and technological circles and medicine circles pay more and more regards for the magnetic resonance imaging apparatus using permanent magnet.

However, the conventional box-shape permanent magnet formed of ferrite magnetic material is low in magnetic intensity, heavy, big in volume, closed and poor in practicability. In the early stage, weight of a magnet of 3000Gs is substantially 100 ton, so that it is difficult to transport and mount the magnet. Subsequently, a new magnetic material, i.e. NdFeB, is developed, many countries invest a lot of work and money in research and development of the magnetic resonance permanent magnet having low field strength. Recently, there is proposed a magnet of so-called open type which has high magnetic energy product, good uniformity, and small volume, this type magnet has the following advantageous: a patient can lie on a half-open examining table, thus eliminating the patient's dread occurring in the conventional MRI examination, so that it is easily acceptable for children or other peevish patients. In addition, during the MRI examination, the patient is not necessary to lie on or lie face down on the examining table, and can seat on the table so as to be examined on a part of the body thereof such as extremities. In addition, it is possible to provide interventional therapy to the patient. Therefore, this type magnet is developed rapidly and a lot of products are available in the market. Since this type magnet is cheap, the market share thereof is increased gradually. However, the above conventional products has a separated structure, the yoke part of the magnet is formed by a plurality of portions assembled to each other, therefore, it is difficult to ensure parallelism of the upper yoke to the lower yoke during manufacturing and assembling, thus deteriorating the performance of the magnet to a certain extent, more particularly, decreasing the mechanical strength of the magnet and affecting the uniformity of the magnetic circuit.

### SUMMARY OF THE INVENTION

Accordingly, in order to solve problems occurring in the conventional magnets formed by a plurality of parts assembled to each other, an object of the present invention is to provide an open-type permanent magnet for magnetic resonance, which has a substantially C-shaped structure with two columns.

The above object is accomplished by providing a permanent magnet comprising: a yoke, magnetic materials, pole heads, plates for eliminating vortex, rings for uniformising magnetic field, and gradient coils. The yoke of the present invention is integrally formed by casting, has a substantially C-shaped and open structure with two columns, the magnetic material is adhesive bonded to the yoke, the pole heads are adhesive bonded to the yoke, plates for eliminating vortex are adhesive bonded to the pole heads respectively, and the gradient coils and rings for uniformising magnetic field are mounted to the pole heads respectively, with the gradient coils located inside and the rings for uniformising magnetic field located outside, each of the rings for uniformising magnetic field is respectively formed of a plurality of arc sections fixed to the pole heads so as to form a ring.

The magnet of the present invention is integrally formed by casting, which has a substantially C-shaped and open structure with two columns, so that it is simply in structure. The magnetic circuit thereof is designed by two-dimensional or three-dimensional simulation using a computer, the magnetic material is formed of consubstantial NdFeB using a series of high and new-technologies and processes, thus ensuring good uniformity and stability, small area of the stray magnetic field, and eliminating substantially vortex effect. The yoke part of the present invention is formed integrally of low carbon steel by casting, the material forming the yoke part is uniform, the crystal grains of the yoke part are uniform and consistent by annealing the material forming the yoke part twice, thus eliminating the internal stress completely. The defects in the yoke part can be eliminated by magnetic particle and ultrasonic inspection, so that the parallelism of the lower yoke to the upper yoke can be ensured to the maximum extent, thus increasing mechanical strength of the yoke frame and ensuring uniformity of the magnetic field and fluency of the magnetic circuit. At the same time, the yoke frame is designed as streamline shape and thereby meets the requirements of the design principle of the magnetic circuit of the magnet, so that the magnet is light, has low flux leakage and good appearance. The magnet of the present invention employs NdFeB as the magnetic material having high performance, thus increasing uniformity of the magnet and eliminating the vortex effect generally occurring in conventional permanent magnet. The base magnetic filed is good, so that the magnetic field can be uniformised easily.

### BRIEF DESCRIPTION OF THE ACCOMPANY DRAWINGS

Fig. 1 is a schematic view of the integral structure of the magnet according to one embodiment of the present invention;
Fig. 2 is a side view of the Fig. 1.
   reference numerals 1: a yoke; 2: magnetic material; 3: pole head; 4: plate for eliminating vortex; 5: field-uniformising ring; 6: gradient coil

### DETAILED DESCRIPTION OF THE PREFERRED EMBODIMENTS OF THE PRESENT INVENTION

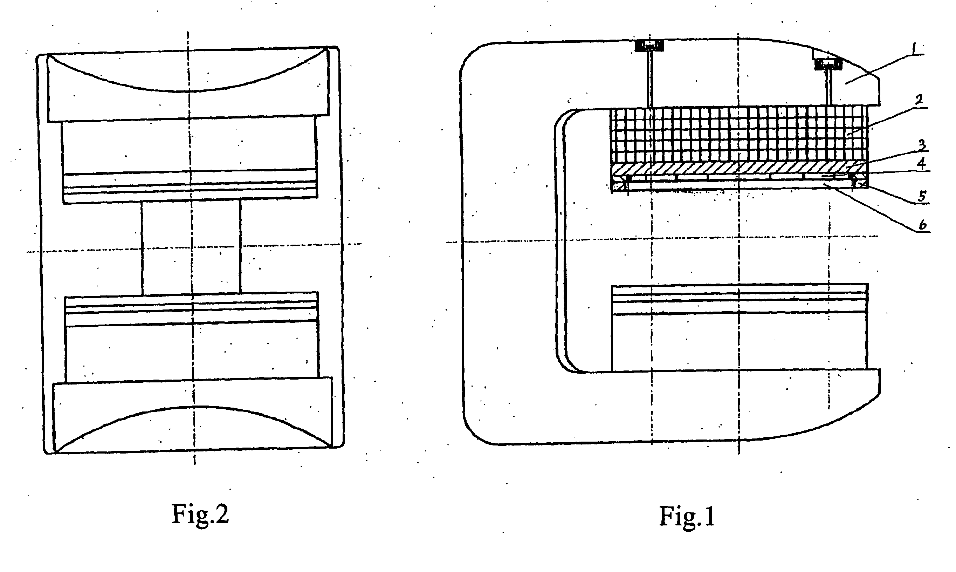

As shown in Fig. 1, the magnet of the present invention comprises a yoke 1, magnetic material 2, pole heads 3, plates for eliminating vortex 4, rings 5 for uniformising magnetic field, and gradient coils 6. The yoke 1 has an integral, substantially C-shaped and opened structure with two columns. The magnetic material 2 is adhesive bonded to the yoke 1, the pole heads 3 are adhesive bonded to the magnetic material 2 respectively, the plates for eliminating vortex 4 are adhesive bonded to the pole heads 3 respectively, the gradient coils 6 and rings 5 for uniformising magnetic field are fixed to the pole heads 3 by screws respectively.

The technical indicators of the magnet according to the present invention are provided in the following table:

| type | 2300 | 3500 |
|---|---|---|
| magnetic field intensity | 2300Gs±50Gs | 3500Gs±50Gs |
| magnetic field direction | vertical | vertical |
| height of air gap | 525mm . | 525mm |
| material | NdFeB | NdFeB |
| structure | open | open |
| 5Gs line | ≼1.8m | ≼2.2m |
| uniformity of magnetic field | ≼20ppm in 30DSV | ≼20ppm in 30DSV |
| uniformising manner | passive | passive |
| stability | 6ppm/h | 6ppm/h |
| operating condition | 21 ± 1 °C | 21 ± 1 °C |

## Claims

1. A permanent magnet for magnetic resonance, comprising:
a yoke;
magnetic material;
pole heads;
plates for eliminating vortex;
rings for uniformising magnetic field; and
gradient coils,
wherein said yoke of the magnet has an integral, substantially C-shaped and open structure with two columns.

2. The permanent magnet for magnetic resonance according to the claim 1, wherein said yoke is integrally manufactured by casting.

3. The permanent magnet for magnetic resonance according to the claim 1or 2, wherein said yoke is formed of low carbon steel material having good magnetic conductivity.

4. The permanent magnet for magnetic resonance according to any one of the claims 1-3, wherein said yoke is annealed twice.

5. The permanent magnet for magnetic resonance according to any one of the claims 1-4, wherein said yoke is designed so as to have a streamline-shape appearance.
